# EUROPÄISCHE PATENTSCHRIFT

(11) **EP 2 071 344 B1**
(45) Veröffentlichungstag und Bekanntmachung des Hinweises auf die Patenterteilung: **24.11.2010**
(21) Anmeldenummer: 08105385.2
(22) Anmeldetag: 19.09.2008
(51) Int. Cl.: G01R 31/36, H01M 10/48

(54) **Verfahren zur Bestimmung der Speichertempertur eines elektrischen Speichers**
Method for determining the store temperature of an electric store
Procédé de détermination de la température d'accumulation d'un accumulateur électrique

(30) Priorität: 17.10.2007 DE 102007049707
(43) Veröffentlichungstag der Anmeldung: 17.06.2009
(73) Patentinhaber: Robert Bosch GmbH, 70442 Stuttgart (DE)
(72) Erfinder: Laczik, Endre, 1043, Budapest (HU); Dertinger, Armin, 1103, Budapest (DE)

(56) Entgegenhaltungen:
- EP-A- 1 420 261
- EP-A- 1 688 722
- DE-A1- 10 131 259
- US-A- 4 342 963
- US-A- 6 160 383

## Beschreibung

Die Erfindung betrifft ein Verfahren zur Bestimmung der an einem Speicherort herrschenden Speichertemperatur eines elektrischen Speichers, insbesondere einer wiederaufladbaren Batterie eines Fahrzeugs, durch Messung einer Korrelationstemperatur an einem Korrelationsort und Ermittlung der Speichertemperatur durch eine in einem Anfangszeitpunkt erfolgende Eingabe der Korrelationstemperatur als Anfangswert in ein das Auseinanderfallen von Speicherort und Korrelationsort berücksichtigendes Temperaturmodell, das die zeitliche Korrelation der Korrelations- und der Speichertemperatur mittels einer Zeitkonstante berücksichtigt.

### Stand der Technik

Ein derartiges Verfahren zur Bestimmung einer Speichertemperatur für einen als wiederaufladbare Batterie eines Fahrzeugs ausgebildeten elektrischen Speicher ist bekannt. Mittels eines elektronischen Batteriesensors (EBS: Electronic Battery Sensor) werden diverse charakteristische Größe der Batterie wie Strom, Spannung und Speichertemperatur mit hoher Abtastrate gemessen beziehungsweise bestimmt. Mittels dieser Größen erfolgt eine Ermittlung des Batteriezustands (BSD: Battery State Detection). Eine Ausgangsgröße des elektronischen Batteriesensors ist die Speichertemperatur der Batterie (Batterietemperatur). Da diese nicht direkt am Speicherort - hier in der Säure der Batterie - gemessen werden kann, wird sie mittels eines als Batterietemperaturmodell ausgebildeten Temperaturmodells aus einem Wert einer an einem Korrelationsort gemessenen Korrelationstemperatur bestimmt. Dazu wird ein Temperaturmodell genutzt, das unter Anderem die zeitliche Korrelation der Korrelations- und der Speichertemperatur mittels einer Zeitkonstante berücksichtigt. Bei Inbetriebnahme des elektronischen Batteriesensors muss die zugrundeliegende Korrelation jedoch nicht gegeben sein. Der Grund dafür kann zum Beispiel in einer Eigenerwärmung der Elektronik des elektronischen Batteriesensors liegen. Daher korrigiert das Temperaturmodell - neben anderen Größen - auch die Eigenerwärmung der Elektronik. Wenn die Elektronik aus einem leistungslosen Zustand oder einem Ruhezustand in einen aktiven Zustand geschaltet wird, kann die Dynamik der Eigenerwärmung als Entspannungstemperaturverhalten beschrieben werden. Im Allgemeinen wird der Wert der ersten gemessenen Korrelationstemperatur nach dem Einschalten als Anfangswert in das Temperaturmodell eingegeben und dient somit zu dessen Initialisierung. Dabei können mehrere Probleme auftreten:
- Bei einer Inbetriebnahme mit noch nicht vorgewärmter Elektronik, insbesondere Messelektronik, kann die erste Messung der Korrelationstemperatur mit einer Zeitverzögerung bezüglich eines Startalgorithmus des elektronischen Batteriesensors erfolgen. Zusätzlich erfasst das Temperaturmodell das zeitliche Verhalten der Speichertemperatur falsch und bestimmt durch eine falsche Korrektur des ersten gemessenen Wertes der Korrelationstemperatur den Anfangswert der Speichertemperatur der Batterie falsch.
- Bei einer Inbetriebnahme des elektronischen Batteriesensors mit vorgewärmter Elektronik nimmt das Temperaturmodell an, dass sich die Elektronik in einem nicht vorgewärmten Zustand befindet und korrigiert den Wert der Korrelationstemperatur entsprechend falsch.
- Bei Rücksetzen der Daten nach einem Austausch der Batterie können der Korrelationsort, der sich hierbei im elektronischen Batteriesensor befindet, und die Batterie starke Temperaturdifferenzen aufweisen, sodass der gemessene Wert der Korrelationstemperatur nicht einer sich zwischen der tatsächlichen Temperatur der Batterie und der Korrelationstemperatur am Korrelationsort einstellenden Gleichgewichtstemperatur entspricht.

In allen Fällen wird dem Temperaturmodell ein falscher Anfangswert der Speichertemperatur der Batterie eingegeben, sodass die Speichertemperatur vom Temperaturmodell falsch bestimmt wird und von der tatsächlichen Temperatur der Batterie abweicht. Dies kann zu Fehlern beim Wiederaufladen der Batterie und zu Fehlinterpretationen bei der Ermittlung des Batteriezustands führen.

Aus der EP-A-1688722 sind bereits eine Einrichtung und Verfahren zur Ermittlung der Temperatur in einer elektrischen Batterie bekannt. Hierzu werden folgende Schritte durchgeführt: Ermitteln mindestens eines elektrischen Leistungswertes in Abhängigkeit von einer mit dem Betrieb der Batterie verknüpften Leistungskenngröße und Ermitteln der Temperatur in der elektrischen Batterie in Abhängigkeit von dem mindestens einen gemessenen Temperaturwert und von dem mindestens einen elektrischen Leistungswert, wobei die an der Temperaturmessstelle umgesetzte elektrische Leistung auch berücksichtigt wird.

### Offenbarung der Erfindung

Zur Reduktion einer Abweichung der bestimmten Speichertemperatur von der tatsächlichen Temperatur des elektrischen Speichers ist vorgesehen, dass innerhalb einer vorgebbaren Zeitspanne beginnend mit dem Anfangszeitpunkt die Zeitkonstante verkleinert (reduziert) oder auf Null gesetzt wird. Das Temperaturmodell ermittelt ab dem Anfangszeitpunkt die Speichertemperatur mittels der Zeitkonstante. Diese wird jedoch zunächst für die vorgebbare Zeitspanne gegenüber dem anschließend genutzten Wert der Zeitkonstante reduziert. Die Speichertemperatur ist somit nach dem Anfangszeitpunkt für die vorgebbare Zeitspanne an die ermittelte Korrelationstemperatur gebunden. Wird die Zeitkonstante auf Null gesetzt, folgt die ermittelte Speichertemperatur der gemessenen Korrelationstemperatur während dieser Zeitspanne.

Dabei wird im einfachsten Fall von folgenden Grundvoraussetzungen ausgegangen: Der elektrische Speicher und eine Messeinrichtung zur Messung der Korrelationstemperatur am Korrelationsort bilden ein thermodynamisches Gleichgewichtssystem, bei dem der Speicherort und der Korrelationsort thermisch miteinander verbunden sind. Durch diese thermische Verbindung kann sich nach hinreichend langer Zeit ein thermodynamisches Gleichgewicht zwischen Korrelationsort und Speicherort einstellen. Weiterhin wird angenommen, dass die thermodynamische Trägheit des elektrischen Speichers deutlich höher ist als die der Messeinrichtung am Korrelationsort. Die die zeitliche Korrelation der Korrelations- und der Speichertemperatur berücksichtigende (unreduzierte) Zeitkonstante des Temperaturmodells wird von der thermodynamischen Trägheit des elektrischen Speichers dominiert. Wird diese auf Null gesetzt, ergibt sich ein verbleibender Zeitparameter, der nur noch durch einen messbaren Zeitparameter der thermodynamischen Trägheit der Messeinrichtung bestimmt wird. Die vorgebbare Zeitspanne wird vorzugsweise so vorgewählt, dass die Bindung der ermittelten Speichertemperatur an die Korrelationstemperatur solange anhält, bis sich das thermische Gleichgewicht zwischen dem Korrelationsort und dem Speicherort des elektrischen Speichers zumindest weitgehend eingestellt hat. Der elektrische Speicher (elektrische Energiespeicher) ist insbesondere eine wiederaufladbare Batterie oder ein Akkumulator, vorzugsweise eine wiederaufladbare Batterie eines Fahrzeugs. Die Bestimmung der Speichertemperatur erfolgt insbesondere mittels einer Vorrichtung, die einerseits eine Plattform bildet, auf der das Temperaturmodell realisiert ist, beziehungsweise das Temperaturmodell bildet oder mitbildet, und gleichzeitig die Messeinrichtung zur Messung der Korrelationstemperatur bereitstellt. Diese weist vorzugsweise einen Temperatursensor (zum Beispiel einen Widerstandstemperatursensor) auf. Mit Vorteil ist die Vorrichtung in einem Außenbereich des elektrischen Speichers angeordnet. Die Vorrichtung ist bevorzugt ein elektronischer Batteriesensor (EBS: Electronic Battery Sensor). Der Korrelationsort befindet sich bevorzugt im Bereich der Elektronik des elektronischen Batteriesensors, insbesondere direkt an/in einer Recheneinrichtung, zum Beispiel einem Mikrocontroller, des elektronischen Batteriesensors.

Weiterhin ist mit Vorteil vorgesehen, dass das Temperaturmodell mindestens eine Korrekturgröße berücksichtigt. Mittels dieser Korrekturgröße werden Störungen, wie zum Beispiel eine Temperaturabweichung, der Elektronik, insbesondere der Recheneinrichtung, durch Eigenerwärmung im Betrieb berücksichtigt.

Mit Vorteil ist das Temperaturmodell ein mathematisches Temperaturmodell. Mit Hilfe des mathematischen Temperaturmodells wird das Auseinanderfallen des Temperaturverhaltens am Speicherort und Korrelationsort nachgebildet. Dieses Temperaturverhalten wird insbesondere von der thermodynamischen Trägheit des elektrischen Speichers bestimmt. Das mathematische Temperaturmodell ist bevorzugt auf der Recheneinrichtung implementiert.

In einer vorteilhaften Ausgestaltung der Erfindung ist vorgesehen, dass die vorgebbare Zeitspanne von einem Gradienten der gemessenen Korrelationstemperatur vorgegeben wird. Sinkt der Gradient der Korrelationstemperatur unter einen ebenfalls vorgebbaren Wert, so ist ein thermisches Gleichgewicht zwischen dem Speicherort des elektrischen Speichers und dem Korrelationsort erreicht oder nahezu erreicht.

Die Erfindung betrifft weiterhin eine Vorrichtung zur Durchführung des vorstehend genannten Verfahrens. Die Vorrichtung ist insbesondere ein elektronischer Batteriesensor.

Mit Vorteil ist vorgesehen, dass die Vorrichtung mindestens eine Schnittstelle als Eingabeeinrichtung zur Eingabe der vorgebbaren Zeitspanne und/oder mindestens eine Komponente zur Bildung des Gradienten der Korrelationstemperatur aufweist. Der Anfangszeitpunkt ergibt sich unmittelbar nach Inbetriebnahme der Vorrichtung. Mittels der Eingabeeinrichtung kann der Vorrichtung - zum Beispiel von einem Batteriemanagementsystem (BMS) - die Zeitspanne vorgegeben werden, in der die Zeitkonstante verkleinert oder auf Null gesetzt wird. Alternativ oder zusätzlich weist die Vorrichtung die Komponente zur Bildung des Gradienten der Korrelationstemperatur auf. Mittels dieser Komponente wird die Zeitspanne als solche Zeitspanne ermittelt, in der der Gradient der Korrelationstemperatur unter einen vorgegebenen Wert gefallen ist.

Mit Vorteil ist vorgesehen, dass die Vorrichtung eine Messeinrichtung mit einem Temperatursensor zur Messung der Korrelationstemperatur und einer Recheneinrichtung zur Bestimmung des Anfangswerts der Speichertemperatur und zur Bestimmung der Speichertemperatur zu einem wählbaren Zeitpunkt aufweist. Die Recheneinrichtung ist bevorzugt auch die Messeinrichtung.

Schließlich ist mit Vorteil vorgesehen, dass die Vorrichtung eine an einem elektrischen Kontakt des elektrischen Speichers kontaktierend befestigbare Vorrichtung ist. Durch die Befestigung am elektrischen Kontakt sind einerseits eine elektrische Kontaktierung und andererseits eine thermische Kontaktierung erreicht. Durch die thermische Kontaktierung steht auch der Temperatursensor der Vorrichtung in einem thermischen Kontakt mit dem elektrischen Speicher. Durch diesen thermischen Kontakt kann sich ein thermisches Gleichgewicht zwischen der Korrelationsort und dem Speicherort einstellen.

### Kurze Beschreibung der Zeichnungen

Die Erfindung wird nachfolgend in einem Ausführungsbeispiel anhand der zugehörigen Zeichnungen näher erläutert. Es zeigen:
- Figur 1: einen elektronischen Batteriesensor, der an einem als wiederaufladbare Batterie ausgebildeten elektrischen Speicher angeordnet ist und
- Figur 2: ein Diagramm, das den Verlauf einer ermittelten Korrelationstemperatur und den Verlauf der ermittelten Speichertemperatur des elektrischen Speichers zeigt.

### Ausführungsform(en) der Erfindung

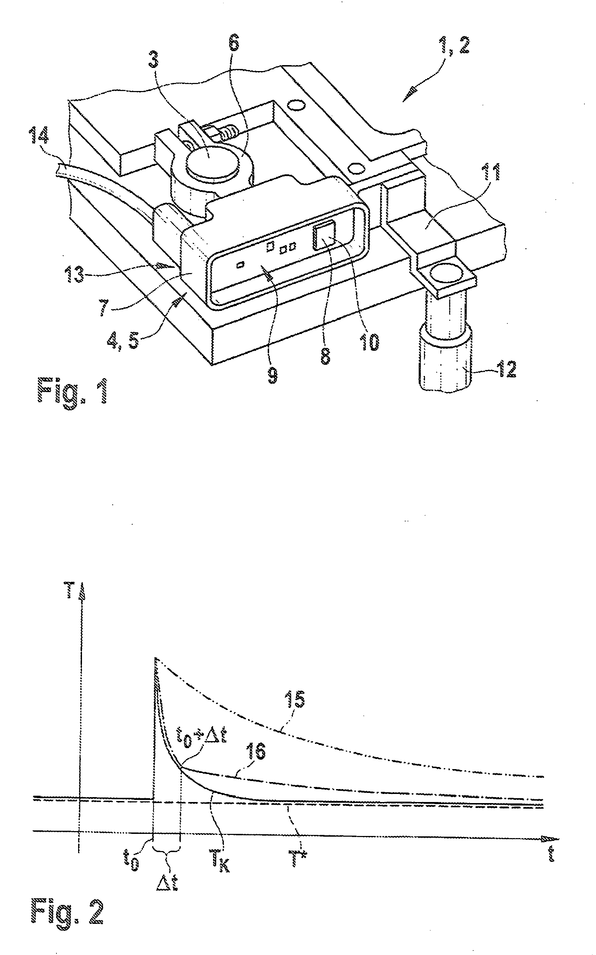

Die Figur 1 zeigt einen als eine wiederaufladbare Batterie 1 ausgebildeten elektrischen Speicher 2 (elektrischen Energiespeicher). Der elektrische Speicher 2 weist einen Massekontakt 3 (Minus-Pol) und einen weiteren nicht dargestellten elektrischen Kontakt (Plus-Pol) auf, der durch die vom elektrischen Speicher 2 aufgebaute Spannung ein anderes (höheres) elektrisches Potential aufweist als der Massekontakt 3. Am Massekontakt 3 ist eine als elektronischer Batteriesensor (EBS: Electronic Battery Sensor) 4 ausgebildete Vorrichtung 5 befestigt. Die Befestigung erfolgt dabei in bekannter Weise über eine lösbare Klemmverbindung, bei der eine Hebelnabe 6 der Vorrichtung 5 den im Wesentlichen zylinderförmig ausgebildeten Massekontakt 3 umfänglich einklemmt. Dabei entsteht ein nahezu vollumfänglicher thermischer und elektrischer Kontakt zwischen der Umfangsfläche des Massekontakts 3 und der Hebelnabe 6. Die Vorrichtung 5 weist weiterhin ein Gehäuse 7 auf, aus dem die Hebelnabe 6 herausragt. Innerhalb des Gehäuses 7 ist eine elektrische beziehungsweise elektronische Schaltungsanordnung 9 angeordnet. In dieser Schaltungsanordnung 9 ist - neben anderen elektronischen Bauelementen - eine Recheneinrichtung 10 verschaltet. Diese als Mikrocontroller ausgebildete Recheneinrichtung 10 bildet eine Messeinrichtung mit Temperatursensor zur Bestimmung der Korrelationstemperatur T_{K} am Korrelationsort 8. Der Korrelationsort 8 in der Recheneinrichtung 10 steht über den Massekontakt 3 und die Hebelnabe 6 mit einem Speicherort im elektrischen Speicher 2 in thermischem Kontakt. Neben der Messeinrichtung zur Bestimmung der Korrelationstemperatur T_{K} weist die Vorrichtung 5 weitere, nicht gezeigte Messeinrichtungen zur Messung von charakteristischen Größen des elektrischen Speichers 2, wie zum Beispiel Strom und Spannung auf. Über einen elektrischen Anschluss 11, der im Gehäuse elektrisch leitend mit der Hebelnabe 6 verbunden ist, ist die Vorrichtung 5 mit einer als Masseleitung ausgebildeten Leitung 12 verbunden. Die Leitung 12 ist ein Stromkabel, das bei herkömmlicher Verschaltung des elektrischen Speichers 2, das heißt ohne die Vorrichtung 5, über eine entsprechende Hebelnabe direkt mit dem Massekontakt 3 elektrisch verbunden wäre. Die Schaltungsanordnung 9 ist über eine Schnittstelle 13 und mindestens eine entsprechende Leitung 14 zum Beispiel mit einem nicht gezeigten Batteriemanagementsystem (BMS) verbindbar.

Es ergibt sich folgende Funktion der Vorrichtung 5 in Bezug auf die Bestimmung der Speichertemperatur T des elektrischen Speichers 2: Mittels des nicht gezeigten Temperatursensors wird die Korrelationstemperatur T_{K} an dem mit dem elektrischen Speicher 2 in thermischem Kontakt stehenden Korrelationsort 8 bestimmt. Aus einem Wert der Korrelationstemperatur T_{K} wird mittels eines in der Recheneinrichtung 10 implementierten Temperaturmodells aus einem Anfangswert der Korrelationstemperatur T_{K} mittels einer Zeitkonstante τ die Speichertemperatur T bestimmt. Nach einer Inbetriebnahme der Vorrichtung 5, wird die Zeitkonstante τ zum Anfangszeitpunkt t₀ für eine vorgebbare Zeitspanne Δt verkleinert oder auf Null gesetzt. Die Speichertemperatur T ist somit nach dem Anfangszeitpunkt t₀ für die vorgebbare Zeitspanne Δt an die aktuell ermittelte Korrelationstemperatur T_{K} gebunden. Die Inbetriebnahme kann dabei eine Inbetriebnahme mit noch nicht vorgewärmter Elektronik der Schaltungsanordnung 8 oder eine Inbetriebnahme mit vorgewärmter Elektronik sein.

Die Speichertemperatur T ergibt sich durch die Reduktion der Zeitkonstante τ - beginnend zum Anfangszeitpunkt t₀ - zunächst für die Zeitspanne Δt zumindest weitgehend aus der Korrelationstemperatur T_{K} und anschließend aus der die zeitliche Korrelation der Korrelations- und der Speichertemperatur berücksichtigenden (unreduzierten) Zeitkonstante τ des Temperaturmodells.

Die Figur 2 zeigt in einem beispielhaften Diagramm den zeitlichen Verlauf der berechneten Speichertemperatur T und der Korrelationstemperatur T_{K} über der Zeit t. Bei Inbetriebnahme der Vorrichtung ist die Korrelationstemperatur T_{K} zum Zeitpunkt t₀ deutlich höher als die tatsächliche Temperatur T* des elektrischen Speichers 2. In dem in der Figur 2 dargestellten Beispiel ist die tatsächliche Temperatur T* des elektrischen Speichers 2 über den gesamten dargestellten Zeitbereich konstant. Die Korrelationstemperatur T_{K} gleicht sich exponentiell an diese tatsächliche Temperatur T* des elektrischen Speichers 2 an. Der zeitliche Verlauf dieser Anpassung wird hauptsächlich von der thermodynamischen Trägheit der Messeinrichtung zur Messung der Korrelationstemperatur, hier von der Recheneinrichtung 10, bestimmt.

Würde nun -wie im Stand der Technik- lediglich der erste nach Inbetriebnahme der Vorrichtung bestimmte Wert der Korrelationstemperatur T_{K} zum Anfangszeitpunkt t₀ als Anfangswert in das Temperaturmodell eingegeben, so würde die Speichertemperatur T ab dem Anfangszeitpunkt t₀ mittels der (unreduzierten) Zeitkonstante τ der zeitlichen Korrelation der Korrelations- und der Speichertemperatur ermittelt werden. Dabei würde sich ein der Funktion 15 entsprechender Verlauf der mittels des Temperaturmodells bestimmten Speichertemperatur T ergeben. Dieser Verlauf zeigt über den gesamten dargestellten Temperaturbereich eine auf einem systematischen Fehler beruhende große Abweichung vom Verlauf der tatsächlichen Temperatur T* am Speicherort.

Um einen derartigen systematischen Fehler zu unterdrücken, wird die Zeitkonstante τ innerhalb der vorgebbaren Zeitspanne Δt beginnend mit dem Anfangszeitpunkt t₀ auf Null gesetzt oder zumindest verringert. Damit folgt die mittels des Temperaturmodells bestimmte Speichertemperatur T für die vorgebbare Zeitspanne Δt der Korrelationstemperatur T_{K}. Die Zeitspanne Δt ist dabei bevorzugt so gewählt, dass sich die Korrelationstemperatur T_{K} im Verlaufe dieser Zeitspanne Δt vollständig oder fast vollständig an die tatsächliche Temperatur T* des elektrischen Speichers angeglichen hat. Die Funktion 16 zeigt den Verlauf der so bestimmten Speichertemperatur T des elektrischen Speichers 2. Durch die erfindungsgemäße Verringerung der Zeitkonstante τ innerhalb der vorgebbaren Zeitspanne Δt beginnend mit dem Anfangszeitpunkt t₀ wird die Abweichung der bestimmten Speichertemperatur T von der tatsächlichen Speichertemperatur verringert.

## Patentansprüche

1. Verfahren zur Bestimmung der an einem Speicherort herrschenden Speichertemperatur eines elektrischen Speichers, insbesondere einer wiederaufladbaren Batterie eines Fahrzeugs, durch Bestimmung einer Korrelationstemperatur an einem Korrelationsort und Ermittlung der Speichertemperatur durch eine in einem Anfangszeitpunkt erfolgende Eingabe der Korrelationstemperatur als Anfangswert in ein das Auseinanderfallen von Speicherort und Korrelationsort berücksichtigendes Temperaturmodell, das die zeitliche Korrelation der Korrelations- und der Speichertemperatur mittels einer Zeitkonstante berücksichtigt, **dadurch gekennzeichnet, dass** innerhalb einer vorgebbaren Zeitspanne beginnend mit dem Anfangszeitpunkt die Zeitkonstante verkleinert oder auf Null gesetzt wird.

2. Verfahren nach Anspruch 1, **dadurch gekennzeichnet, dass** das Temperaturmodell mindestens eine Korrekturgröße berücksichtigt.

3. Verfahren nach einem der vorhergehenden Ansprüche, **dadurch gekennzeichnet, dass** der Korrelationsort in einem Außenbereich des elektrischen Speichers angeordnet ist.

4. Verfahren nach einem der vorhergehenden Ansprüche, **dadurch gekennzeichnet, dass** die Bestimmung der Speichertemperatur eine Berechnung der Speichertemperatur ist.

5. Verfahren nach einem der vorhergehenden Ansprüche, **dadurch gekennzeichnet, dass** das Temperaturmodell ein mathematisches Temperaturmodell ist.

6. Verfahren nach einem der vorhergehenden Ansprüche, **dadurch gekennzeichnet, dass** die vorgebbare Zeitspanne von einem Gradienten der Korrelationstemperatur vorgegeben wird.

## Claims

1. A method for determining the storage temperature, present at a storage location, of an electric accumulator, in particular of a rechargeable battery of a vehicle, by determining a correlation temperature at a correlation location and acquiring the storage temperature by inputting the correlation temperature, at an initial time, as a starting value into a temperature model which takes into account the divergence between the storage location and the correlation location, and takes into account the chronological correlation between the correlation temperature and the storage temperature by means of a time constant, **characterized in that** the time constant is reduced or set to zero within a predefinable time period starting with the starting time.

2. Method according to Claim 1, **characterized in that** the temperature model takes into account at least one correction variable.

3. Method according to one of the preceding claims, **characterized in that** the correlation location is arranged in an outer region of the electric accumulator.

4. Method according to one of the preceding claims, **characterized in that** the determination of the storage temperature is a calculation of the storage temperature.

5. Method according to one of the preceding claims, **characterized in that** the temperature model is a mathematical temperature model.

6. Method according to one of the preceding claims, **characterized in that** the predefinable time period is predefined by a gradient of the correlation temperature.

## Revendications

1. Procédé pour déterminer la température d'accumulateur d'un accumulateur électrique qui règne à l'endroit d'un accumulateur, notamment une batterie rechargeable d'un véhicule, en déterminant une température de corrélation en un endroit de corrélation et en déterminant la température d'accumulateur par une entrée s'effectuant à un instant initial de la température de corrélation en tant que valeur initiale dans un modèle de température tenant compte de la rupture entre l'endroit de l'accumulateur et l'endroit de la corrélation et qui tient compte de la corrélation dans le temps entre la température de corrélation et la température d'accumulateur au moyen d'une constante de temps, **caractérisé en ce que** la constante de temps est réduite ou mise à zéro dans un intervalle de temps qui peut être prédéfini qui commence par l'instant initial.

2. Procédé selon la revendication 1, **caractérisé en ce que** le modèle de température tient compte d'au moins une grandeur de correction.

3. Procédé selon l'une des revendications précédentes, **caractérisé en ce que** l'endroit de la corrélation se trouve dans une zone extérieure de l'accumulateur électrique.

4. Procédé selon l'une des revendications précédentes, **caractérisé en ce que** la détermination de la température d'accumulateur est un calcul de la température d'accumulateur.

5. Procédé selon l'une des revendications précédentes, **caractérisé en ce que** le modèle de température est un modèle de température mathématique.

6. Procédé selon l'une des revendications précédentes, **caractérisé en ce que** l'intervalle de temps qui peut être prédéfini est prédéfini par un gradient de la température de corrélation.
